# EUROPEAN PATENT APPLICATION

(11) **EP 3 276 760 A1**
(43) Date of publication of application: **31.01.2018**
(21) Application number: 17183483.1
(22) Date of filing: 27.07.2017
(51) Int. Cl.: H01S 5/10, H01S 5/30

(54) **SOLID-STATE ACTIVE MEDIUM AND A SEMICONDUCTOR LASER COMPRISING THE SAME**

(30) Priority: 27.07.2016 BY 20160286
(71) Applicant: The State Scientific Institution "B.I. Stepanov Institute of Physics of National Academy of Sciences of Belarus", 220072 Minsk (BY); King Abdulaziz City for Science and Technology, 11442 Riyadh (SA)
(72) Inventor: Leanenia, Maksim Sergeevich, 220117 Minsk (BY); Yablonskii, Gennadii Petrovich, 220131 Minsk (BY); Lutsenko, Evgenii Viktorovich, 220018 Minsk (BY); Alyamani, Ahmed Y., 11442 Riyadh (SA); Alanazi, Lafi M., 11442 Riyadh (SA); Aljohani, Maher M., 11442 Riyadh (SA); Aljariwi, Abdulaziz A., 11442 Riyadh (SA)
(74) Representative: Gulde & Partner

(57) **Abstract**

The invention provides a solid-state active medium (2) for a semiconductor laser (10), the active medium (2) comprising or consisting of a mixture of at least three types of semiconductor powders, wherein each of the at least three types of semiconductor powders have the general formula ZnₓCd₁₋ₓS_{y}Se_{1-y} with x and y each being a value between 0 and 1. The semiconductor laser (10) comprises the solid-state active medium (2), and a pump system (1) capable of emitting a pump radiation (3) in the near-UV to violet spectral range.

## Description

The present invention relates to laser technology, in particular to semiconductor lasers, and can be used to create optically pumped lasers with white light emission for applications in imaging systems, lighting, data processing and transmission, document security and remote control.

### BACKGROUND

A laser with random lasing of white light is already known. It comprises an active medium, that is based on a solution of three dyes and passive scattering crystallites (Sh. Chen, X. Zhao, Y. Wang, J. Shi, D. Liu. White light emission with red-green-blue lasing action in a disordered system of nanoparticles. Applied physics letters (2012) Vol. 101, p. 123508-1 - 123508-4). A key feature of that laser is simultaneous lasing at three wavelengths in the blue, green and red spectral regions, which in sum forms white light, under optical pump at a wavelength of 355 nm. The feedback in that laser is achieved by random formation of amplification loops between passive scattering crystallites.

The disadvantage of such a laser is a characteristic for dye lasers low radiation resistance, the limited selection of dyes with intense absorption bands of the pump light in near-UV - violet spectral range, bulky of active medium and the need to maintain the dye solution with passive scattering crystallites suspended in order to achieve high uniformity of the active medium, which greatly limits the application of such lasers.

### GENERAL DESCRIPTION OF THE INVENTION

The goal of the present invention is to develop a laser with simultaneous lasing on the set of wavelengths at the same time in the visible spectrum, which in sum forming white light, in the solid-state active medium, which will significantly simplify the design and reduce the laser dimensions, as well as increase the white light brightness, multiply increase the lifetime due to enhanced degradation resistance of the solid-state active medium.

This goal is achieved by providing a laser based on an solid-state active medium on the basis of direct-gap semiconductors.

More particularly, the solid-state active medium for a laser according to the invention comprises or consists of a mixture of at least three types of semiconductor powders, wherein each of the at least three types of semiconductor powders have the general formula ZnₓCd₁₋ₓS_{y}Se_{1-y} with x and y each being a value between 0 and 1.

The at least three types of semiconductor powders are preferably in a crystalline or semicrystalline state.

According to embodiments, the semiconductor powders have the general formula ZnS_{y}Se_{1-y} with y being a value between 0 and 1, and/or formula SeS_{y}Se_{1-y} with y being a value between 0 and 1.

The semiconductor powders may be selected from the group comprising or consisting of ZnS, ZnS_{0.1}Se_{0.9}, ZnS_{0.2}Se_{0.8}, ZnS_{0.3}Se_{0.7}, ZnS_{0.4}Se_{0.6}, ZnS_{0.5}Se_{0.5}, ZnS_{0.6}Se_{0.4}, ZnS_{0.7}Se_{0.3}, ZnS_{0.8}Se_{0.2}, ZnS_{0.9}Se_{0.1}, ZnSe, CdS, CdS_{0.9}Se_{0.1}, CdS_{0.8}Se_{0.2}, CdS_{0.7}Se_{0.3}, CdS_{0.6}Se_{0.4}, CdS_{0.5}Se_{0.5}, CdS_{0.4}Se_{0.6}, CdS_{0.3}Se_{0.7}, CdS_{0.2}Se_{0.8}, CdS_{0.9}Se_{0.1}, and CdSe.

In specific embodiments, the semiconductor powders are selected from the group comprising or consisting of ZnSe, CdS, CdS_{0.8}Se_{0.2}, and CdS_{0.2}Se_{0.8}.

According to embodiments, the semiconductor powders are selected such that at least one powder is capable of emitting photoluminescence in the blue spectral region, at least one powder is capable of emitting photoluminescence in the green spectral region, and at least one powder is capable of emitting photoluminescence in the red spectral region, when irradiated with a radiation in the near-UV to violet spectral range.

Preferably, the semiconductor powders are selected such that the sum of the photoluminescence emissions of the powder forms white light.

According to embodiments, the semiconductor powders have an average crystallite size the range 100 nm to 50 µm, preferably from 100 nm to 10 µm.

According to another aspect of the present invention, there is provided a semiconductor laser comprising the solid-state active medium according to the invention, and a pump system capable of emitting a pump radiation in the near-UV to violet spectral range.

The pump system may comprise a tunable Ti:Al₂O₃-laser.

Thus, the present invention provides a preferably "white" semiconductor laser, which is comprised of a solid-state active medium and pump system on the basis of pulsed laser with radiation in the near-UV - violet spectral range. The active medium is made of a mixture of at least three types of micron-sized II-VI semiconductor powders with the general formula ZnₓCd₁₋ₓS_{y}Se_{1-y}. The crystallites in the mixture act both as active and scattering medium, wherein lasing simultaneously in the blue, green and red spectral regions, which in sum forms white light, is achieved by formation of random feedback loops when the optical excitation threshold is exceeded.

The fabrication method of "white" semiconductor laser is comprised of the fabrication of active medium from the mixture of micron sized powders. The powders of undoped semiconductors with general formula ZnₓCd₁₋ₓSySe_{1-y}, each of which has a photoluminescence separately in blue, green and red spectral regions, are synthesized, fractionated to achieve a high uniformity of crystallite size with the range from hundreds of nanometers to several micrometers, mixed and deposited on a flat surface.

### DETAILED DESCRIPTION OF THE INVENTION

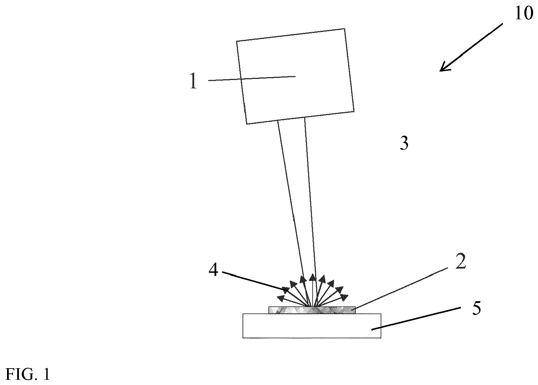

The invention is illustrated in Figure 1, showing a semiconductor laser 10 according to the invention. The semiconductor laser 10 comprises a pump system 1 emitting a radiation 3 which is focused on the surface of an active medium 2 based on a mixture of micron sized semiconductor powders.

The device operates as follows. The radiation 3 of the pump system 1 is focused on the surface of the solid state active medium 2 to form a circular spot of optical excitation with diameter of several hundred micrometers. The pump radiation due to scattering penetrates into the active medium and, thus, is uniformly distributed in the volume of the active medium under excitation spot, causing intense photoluminescence in a mixture of semiconductor crystallites in the blue, green and red regions of the spectrum. Population inversion and stimulated emission in active crystallites is achieved within sufficient pump intensity. Random lasing simultaneously on the set of wavelengths in the blue, green and red regions of the spectrum is achieved while exceeding threshold pump intensity due to the random creation of feedback for stimulated emission within multiple scattering of light in the mixture. Laser radiation 4 on the set of wavelengths in the visible spectrum extends from the active medium in the form of white light in the solid angle without a predetermined direction due to scattering on crystallites.

### Example

The example of the invention is "white" semiconductor laser, that is comprised of active medium based on a mixture of equal weight fractions of ZnSe, CdS, CdS_{0.8}Se_{0.2} and CdS_{0.2}Se_{0.8} micropowders, deposited in form of thin layers on polished quartz plates 5, and the pump system 1 of tunable Ti:Al₂O₃-laser and quartz focusing spherical lens. The radiation of the pump laser at a wavelength of 390 nm with 10 ns pulse duration at repetition frequency of 10 Hz is focused in a circular spot with diameter of 100 microns on the surface of the active medium, causing intense photoluminescence in the blue, green, orange and red spectral regions in ZnSe, CdS, CdS_{0.8}Se_{0.2} and CdS_{0.2}Se_{0.8} crystallites, respectively. The lasing in the active medium is achieved simultaneously at four wavelengths of about 460 nm, 520 nm, 580 nm and 660 nm after exceeding the threshold excitation power density. The sum of the emission spectrum forms white light with high brightness, which propagates without a predetermined direction.

## Claims

1. Solid-state active medium (2) for a semiconductor laser (10), the active medium (2) comprising or consisting of a mixture of at least three types of semiconductor powders, wherein each of the at least three types of semiconductor powders have the general formula ZnₓCd₁₋ₓSySe_{1-y} with x and y each being a value between 0 and 1.

2. Solid-state active medium (2) according to claim 1, wherein the semiconductor powders have the general formula ZnS_{y}Se_{1-y} with y being a value between 0 and 1, and/or formula SeS_{y}Se_{1-y} with y being a value between 0 and 1.

3. Solid-state active medium (2) according to claim 1 or 2, wherein the semiconductor powders are selected from the group comprising or consisting of ZnS, ZnS_{0.1}Se_{0.9}, ZnS_{0.2}Se_{0.8}, ZnS_{0.3}Se_{0.7}, ZnS_{0.4}Se_{0.6}, ZnS_{0.5}Se_{0.5}, ZnS_{0.6}Se_{0.4}, ZnS_{0.7}Se_{0.3}, ZnS_{0.8}Se_{0.2}, ZnS_{0.9}Se_{0.1}, ZnSe, CdS, CdS_{0.9}Se_{0.1}, CdS_{0.8}Se_{0.2}, CdS_{0.7}Se_{0.3}, CdS_{0.6}Se_{0.4}, CdS_{0.5}Se_{0.5}, CdS_{0.4}Se_{0.6}, CdS_{0.3}Se_{0.7}, CdS_{0.2}Se_{0.8}, CdS_{0.9}Se_{0.1}, and CdSe.

4. Solid-state active medium (2) according to any one of claims 1 to 3, wherein the semiconductor powders are selected from the group comprising or consisting of ZnSe, CdS, CdS_{0.8}Se_{0.2}, and CdS_{0.2}Se_{0.8}.

5. Solid-state active medium (2) according to any one of claims 1 to 4, wherein the semiconductor powders are selected such that at least one powder is capable of emitting photoluminescence in the blue spectral region, at least one powder is capable of emitting photoluminescence in the green spectral region, and at least one powder is capable of emitting photoluminescence in the red spectral region, when irradiated with a radiation in the near-UV to violet spectral range.

6. Solid-state active medium (2) according to any one of claims 1 to 5, wherein the semiconductor powders are selected such that the sum of the photoluminescence emissions of the powder forms white light.

7. Solid-state active medium (2) according to any one of claims 1 to 6, wherein the semiconductor powders have an average crystallite size the range 100 nm to 50 µm, preferably from 100 nm to 10 µm.

8. Semiconductor laser (10) comprising the solid-state active medium (2) according to any one of claims 1 to 7, and a pump system (1) capable of emitting a pump radiation (3) in the near-UV to violet spectral range.

9. Semiconductor laser (10) according to claim 8, wherein the pump system (1) comprises a tunable Ti:Al₂O₃-laser.
